# FASCICULE DE BREVET EUROPEEN

(11) **EP 1 894 262 B1**
(45) Date de publication et mention de la délivrance du brevet: **23.01.2013**
(21) Numéro de dépôt: 06777292.1
(22) Date de dépôt: 09.06.2006
(51) Int. Cl.: H01L 51/50

(54) **DIODE ORGANIQUE ELECTROLUMINESCENTE NE COMPRENANT AU PLUS QUE DEUX COUCHES DE MATERIAUX ORGANIQUES DIFFERENTS**
LICHTEMITTIERENDE ORGANISCHE DIODE MIT NICHT MEHR ALS ZWEI SCHICHTEN AUS VERSCHIEDENEN ORGANISCHEN MATERIALIEN
LIGHT-EMITTING ORGANIC DIODE COMPRISING NOT MORE THAN TWO LAYERS OF DIFFERENT ORGANIC MATERIALS

(30) Priorité: 10.06.2005 FR 0551574
(43) Date de publication de la demande: 05.03.2008
(73) Titulaire: Thomson Licensing, 92130 Issy-les-Moulineaux (FR)
(72) Inventeur: VAUFREY, David, F-35000 Rennes (FR); MARTINEZ, Jean-Claude, F-35131 Chartres De Bretagne (FR); CINA, Salvatore, F-35000 Rennes (FR)
(74) Mandataire: Browaeys, Jean-Philippe
(86) Numéro de dépôt international: PCT/EP2006/063069
(87) Numéro de publication internationale: WO 2006/131565

(56) Documents cités:
- EP-A- 1 017 118
- EP-A- 1 071 145
- EP-A- 1 347 518
- US-A1- 2003 111 666
- US-A1- 2004 251 816
- US-B1- 6 528 188
- GANZORIG CHIMED ET AL: "Improved drive voltages of organic electroluminescent devices with an efficient p-type aromatic diamine hole-injection layer" APPLIED PHYSICS LETTERS, AIP, AMERICAN INSTITUTE OF PHYSICS, MELVILLE, NY, US, vol. 77, no. 25, 18 décembre 2000 (2000-12-18), pages 4211-4213, XP012026965 ISSN: 0003-6951
- HARADA K ET AL: "Realization of organic pn-homojunction using a novel n-type doping technique" PROCEEDINGS OF THE SPIE, SPIE, BELLINGHAM, VA, US, vol. 5464, septembre 2004 (2004-09), pages 1-9, XP002317497 ISSN: 0277-786X
- KIDO ET AL: "Bright organic electroluminescent devices having a metal-doped electron-injecting layer", APPLIED PHYSICS LETTERS, vol. 73, no. 20, 16 November 1998 (1998-11-16), pages 2866-2868, XP012021409,
- ENDO ET AL: "Organic electroluminescent devices with a vacuum deposited lewis acid doped hole injecting layer", JAPANESE JOURNAL OF APPLIED PHYSICS, vol. 41, 15 March 2002 (2002-03-15), pages 358-360, XP001186612,

## Description

L'invention concerne une diode organique électroluminescente. L'invention concerne également les panneaux d'éclairage ou d'affichage d'images comprenant un réseau de ces diodes supportées par un même substrat.

Le document EP0498979 B1 - TOSHIBA divulgue une diode organique électroluminescente comprenant :
- un substrat,
- une cathode en matériau conducteur M1 et une anode en matériau conducteur M2,
- une première couche au contact de la cathode, à base d'un premier matériau organique O1 qui est dopé n,
- une deuxième couche au contact de l'anode, à base d'un deuxième matériau organique O2 qui est dopé p,
- et une troisième couche intercalée entre la première couche et la deuxième couche, à base d'un troisième matériau organique 03 qui n'est pas dopé n ni dopé p.

L'article de Chimed Ganzorig et al, intitulé "Improved drive voltages of organic electroluminescent devices with an efficient p-type aromatic diamine hole-injection layer" (Applied Physics Letters, Vol. 77, No. 25, 4211-4213) décrit une diode organique comprenant principalement deux couches : une couche en Alq3, qui peut être dopé n sur une très faible épaisseur, et une couche en TPD, qui est dopé p sur toute son épaisseur. On ajoute aussi une fine couche de C6H5COOLi entre la cathode et la couche d'Alq3. L'article analyse différent types de dopage p du matériau TPD.

L'article de Jun ENDO et al., intitulé « Organic Electroluminescent devices with a Vacuum-Deposited Lewis-Acid-Doped Hole-Injecting Layer » (Japanese Journal of Applied Physics Letters, Vol. 41, No. 3B, L358-L360) décrit une diode organique comprenant uniquement deux couches : une couche en Alq3, qui n'est pas dopé n, et une couche de NPD, qui est dopé p sur une partie seulement de son épaisseur qui est au contact de l'anode.

L'article de Kido et al., intitulé « Bright Organic Electroluminescent Devices having a metal-doped electron-injecting layer » (Applied Physics Letters, Vol. 73, No. 20, 2866-2868), cité dans le précédent article, analyse le dopage n de couches d'Alq3 et les limites d'épaisseur de ce dopage vis-à-vis des risques d'extinction de luminescence dans cette couche.

Le doument US 6528 198 décrit une diode organique dans laquelle la couche électroluminescente est formée de deux couches, une couche transporteuse de trous électroluminescente et une couche transporteuse. d'éléctrons électroluminescente.

En référence à la figure 1, les documents US2004-062949 - NOVALED et US6566807 ajoutent à cette structure à couches dopées des couches de blocage : couche de blocage des électrons en matériau 04 intercalée entre la couche 02 d'injection des trous et la couche électroluminescente 03, couche de blocage des trous en matériau O5 intercalée entre la couche O1 d'injection des électrons et la couche électroluminescente 03.

Ces documents spécifient les propriétés électroniques requises des différents matériaux organiques des différentes couches.

Pour définir ces caractéristiques, on définit notamment les paramètres suivants :
- le travail de sortie (« work function » en langue anglaise) du matériau conducteur de la cathode E_{M1} et celui du matériau conducteur de l'anode E_{M2};
- l'énergie du niveau du LUMO (« Lowest Unoccupied Molecular Orbital » en langue anglaise), celle du niveau du HOMO (« Highest Occupied Molecular Orbital » en langue anglaise) respectivement du matériau de base O1 de la couche dopée n : E_{O1C}, E_{O1V}, du matériau de base O5 de la couche de blocage des trous : E_{O5C}, E_{O5V}, du matériau de base 03 de la couche

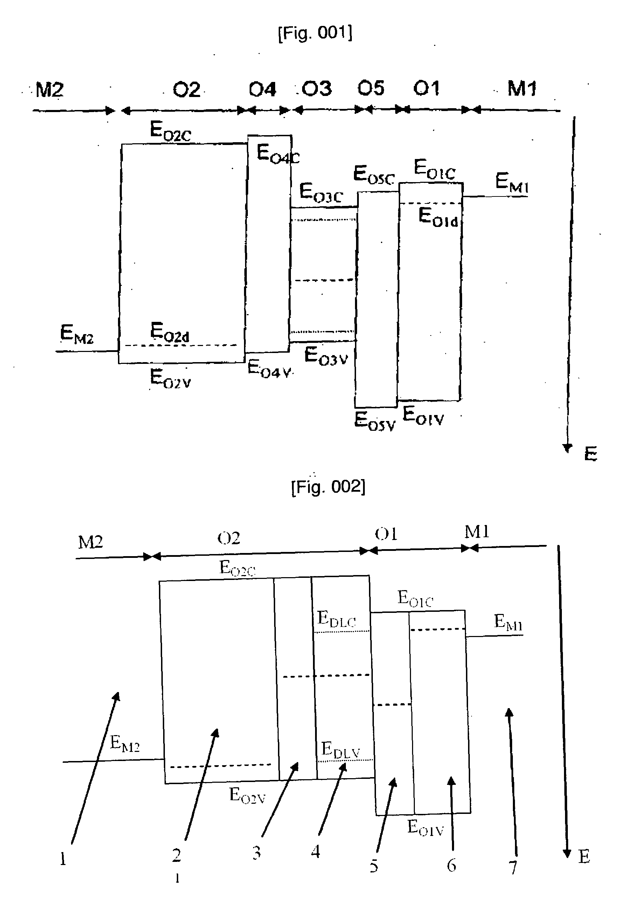

Comme illustré sur la figure 1, pour obtenir un fonctionnement optimal de la diode, selon ces documents, il importe que :
- E_{M1} ≥ E_{O1C}, ce qui signifie qu'il existe une barrière de potentiel à l'interface entre la cathode et la couche organique dopée n, et que la jonction à cette interface n'est pas ohmique ; on peut limiter la hauteur de la barrière de potentiel à 0,5 eV, ou, en cas de barrière plus élevée, adapter en conséquence le niveau de dopage pour faciliter le passage des électrons au travers de cette barrière ; si l'on définit par E_{O1F} le niveau de Fermi des électrons dans la zone dopée comme le barycentre des niveaux occupés, il est préférable que le niveau de dopage soit tel que F_{O1F} ≥ E_{M1} ;
- E_{M2} ≤ E_{O2V}, ce qui signifie qu'il existe une barrière de potentiel à l'interface entre l'anode et la couche organique dopée p, et que la jonction à cette interface n'est pas ohmique ; on peut limiter la hauteur de la barrière de potentiel à 0,5 eV, ou, en cas de barrière plus élevée, adapter en conséquence le niveau de dopage pour faciliter le passage des trous au travers de cette barrière ; si l'on définit par E_{O2F} le niveau de Fermi des trous dans la zone dopée comme le barycentre des niveaux occupés, il est préférable que le niveau de dopage soit tel que E_{O2F} ≤ E_{M2}.

Selon les conditions ci-dessus, les porteurs, électrons ou trous, sont donc injectés par effet tunnel à travers ce qu'on appelle une « zone de déplétion » située dans la zone dopée à proximité immédiate de l'interface avec l'électrode, cathode ou anode ; et, comme l'enseigne le document EP0498979 B1 (page 9, ligne 11-12), l'épaisseur de cette « zone de déplétion » est très faible, à savoir généralement inférieure à 10 nm ; cette épaisseur dépend évidemment des matériaux utilisés et des niveaux de dopage.

Comme illustré sur la figure 1, pour obtenir un fonctionnement optimal de la diode, il importe également que :
- E_{O5C} ≥ E_{O1C} - 0,3 eV, de manière à faciliter le passage des électrons à l'interface entre la couche dopée n en matériau O1 et la couche de blocage des trous en matériau 05, et, de préférence, E_{O5C} ≤ E_{O1C} + 0,3 eV pour limiter les pertes électriques à cette interface ;
- E_{O4V} ≤ E_{O2V} + 0,3 eV, de manière à faciliter le passage des trous à l'interface entre la couche dopée p en matériau 02 et la couche de blocage des électrons en matériau 04, et, de préférence, E_{O4V} ≥ E_{O2V} - 0,3 eV pour limiter les pertes électriques à cette interface ;

Comme illustré sur la figure 1, pour obtenir un fonctionnement optimal de la diode, il est préférable également que :
- E_{O4C} < E_{O3C}, de manière à bloquer efficacement les électrons à l'interface entre la couche électroluminescente en matériau 03 et la couche de blocage des électrons en matériau 04 ;
- E_{O4V} + 0,3 eV ≥ E_{O3V}, de manière à permettre le passage des trous à cette interface, et, de préférence, E_{O4V} - 0,3 eV ≤ E_{O3V} pour limiter les pertes électriques à cette interface ;
- Eosv > E_{O3V}, de manière à bloquer efficacement les trous à l'interface entre la couche électroluminescente en matériau 03 et la couche de blocage des trous en matériau O5 ;
- E_{O5C} - 0,3 eV ≤ E_{O3C}, de manière à permettre le passage des électrons à cette interface, et, de préférence, E_{O5C} + 0,3 eV ≥ E_{O3C} pour limiter les pertes électriques à cette interface ;

Les avantages apportés par l'utilisation de couches organiques dopées pour injecter et transporter des charges, électrons ou trous, dans la couche émissive électroluminescente, au lieu de couches d'injection et de transport de charges de l'art antérieur, sont notamment les suivants :
- rendement électrique élevé ;
- élargissement de la gamme de matériaux organiques semi-conducteurs utilisables, puisqu'un niveau de LUMO inférieur au travail de sortie du matériau de la cathode n'est plus rédhibitoire pour l'injection d'électrons, et puisqu'un niveau de HOMO supérieur au travail de sortie du matériau de l'anode n'est plus rédhibitoire pour l'injection de trous,
- élargissement de la plage des épaisseurs utilisables pour les couches d'injection ou de transport de charges, sans entraîner des pertes ohmiques rédhibitoires du fait de la conductivité élevée des couches dopées ; ceci permet notamment de mieux adapter l'épaisseur pour optimiser l'extraction de lumière par effets interférentiels.

Un inconvénient des structures de diodes électroluminescentes décrites dans les documents précités est que, pour tirer pleinement partie des avantages apportés par les couches dopées à la fois du côté de la cathode et du côté de l'anode, il convient d'utiliser au moins trois matériaux organiques différents. En effet, les structures à seulement deux matériaux organiques telles que décrites en référence aux figures 9 et 12 du document EP0498979 B1 - TOSHIBA ne sont dopées électroniquement n ou p que d'un seul côté, soit du côté de l'anode, soit du côté de la cathode, ce qui ne permet pas de tirer pleinement partie des avantages apportés par les couches dopées. Toutes les autres structures décrites dans ces document comprennent au moins trois matériaux organiques différents entre la cathode et l'anode.

Un but de l'invention est d'apporter une solution à ce problème.

A cet effet, l'invention a pour objet une diode organique électroluminescente telle que décrite dans la revendication 1.

Les dopants p et n sont des dopants électroniques, par opposition au(x) dopant(s) luminescent(s) qui dopent généralement le matériau organique dans la zone électroluminescente.

La diode selon l'invention est beaucoup plus facile et économique à réaliser que les diodes de l'art antérieur, puisqu'elles ne comprennent que deux couches de matériau or ganique de base qui sont en général différents, et puisqu'elles présentent un rendement élevé grâce à l'utilisation de matériaux semi-conducteurs dopés à la fois pour l'injection et le transport des électrons du côté de la cathode et pour l'injection et de transport des trous du côté de l'anode. L'invention s'applique tout particulièrement aux cas où les matériaux organiques ne sont pas polymérisés, et sont donc déposables par évaporation sous vide ; l'obtention des différentes zones peut alors avantageusement être obtenue par simple co-évaporation d'un dopant.

On entend par matériau de base le matériau « hôte » de chaque zone : ainsi, dans une même couche à base d'un même matériau, on peut trouver une zone dopée comprenant par exemple 5% en masse d'un dopant électronique de type n réparti dans ce matériau de base, une zone barrière non dopée en dopant électronique ou luminescent, ne comprenant que ce matériau de base aux impuretés près provenant de la diffusion des zones adjacentes, et une zone dopée comprenant par exemple 8% en masse d'un dopant luminescent réparti dans ce matériau de base : ces trois zones sont à base du même matériau « hôte ». Chaque zone dopée peut contenir une pluralité de dopants.

De préférence, ladite diode ne comprend donc aucune autre couche intercalée entre ladite cathode et ladite anode qui serait à base d'un matériau différent à la fois du premier matériau organique et du deuxième matériau organique.

Selon une variante, ne faisant pas partie de l'invention, les premier et deuxième matériaux organiques sont identiques (voir figure 5). Mais, suivant l'invention, et contrairement aux diodes décrites dans les documents EP1347518 (voir quatrième mode de réalisation page 10), EP1071145 qui décrit des homojonctions, HARADA K intitulé « realization of organic pn-homojunction » - Proceeding of the SPIE, vol. 5464, sept. 2004, pages 1-9 (XP002314797), ledit deuxième matériau organique est différent dudit premier matériau organique. L'utilisation de deux matériaux différents permet d'obtenir de meilleurs rendements tout en limitant la complexité du procédé de fabrication.

La première ou la deuxième couche, ou les deux couches, présentent donc une zone ou « tranche » dopée qui est située au voisinage d'une électrode de la diode, cathode ou anode, et une zone ou « tranche » non dopée qui est luminescente et située au voisinage de l'autre couche.

Le dopant électronique des zones dopées n ou p est adapté d'une manière connue en elle-même pour apporter des niveaux d'énergie supplémentaires à des électrons au voisinage du niveau du LUMO s'il s'agit de dopage de type n, ou pour apporter des niveaux d'énergie supplémentaires à des trous au voisinage du niveau du HOMO s'il s'agit de dopage de type p. Ces dopants n ou p sont ainsi qualifiés de dopants « électroniques » par opposition aux dopants « luminescents » décrits ci-après.

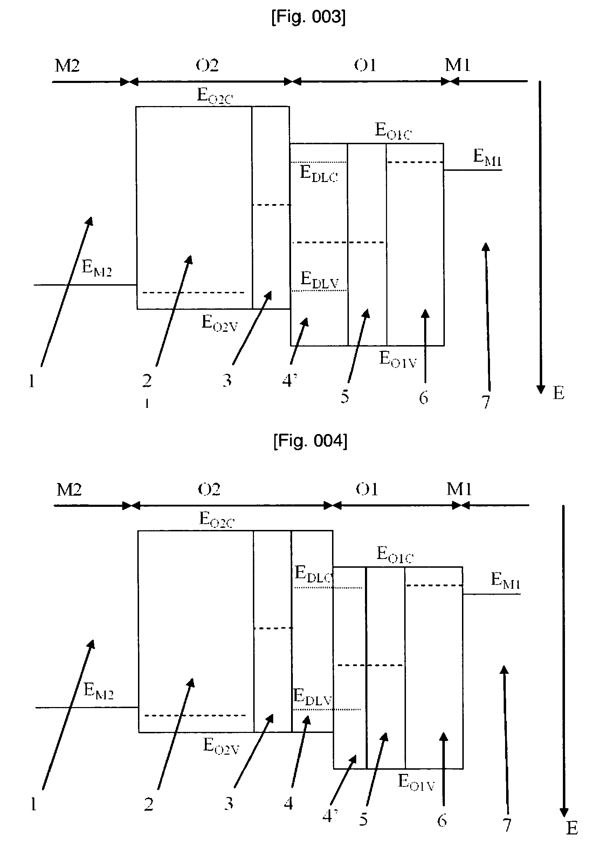

La diode peut présenter une seule zone luminescente qui fait partie de la première couche (voir figure 3), cas ne faisant pas partie de l'invention, ou une seule zone luminescente qui fait partie de la deuxième couche (voir figure 2) , cas ne faisant pas partie de l'invention, ou deux zones luminescentes, l'une faisant partie de la première couche et l'autre faisant partie de la deuxième couche (voir figure 4), suivant l'invention, Le caractère électroluminescent de la zone électroluminescente est notamment obtenu d'une manière connue en elle-même par dopage luminescent du matériau organique de la couche à laquelle cette zone appartient à l'aide d'au moins un dopant fluorescent et/ou phosphorescent. On peut en outre ajouter un dopant colorant pour adapter le spectre d'émission de luminescence de la diode. Certains matériaux présentent intrinsèquement des propriétés d'électroluminescence et peuvent également être transporteurs d'un des porteurs à la fois, électrons ou trous. On peut associer à ce matériau « hôte » un dopant mais ce n'est pas nécessaire. Les matériaux luminescents « hôte » intrinsèquement luminescents peuvent être fluorescents ou phosphorescents.

L'épaisseur de la zone dopée n de la première couche et celle de la zone dopée p de la deuxième couche sont supérieures à 20 nm. Ces épaisseurs élevées permettent d'optimiser l'extraction de lumière sans augmenter sensiblement les pertes ohmiques, puisque le dopage apporte à ces zones une conductivité élevée.

De préférence, la diode selon l'invention comprend également au moins une zone barrière de diffusion, qui n'est pas substantiellement dopée, et qui est intercalée entre une desdites zones dopées et une desdites zones électroluminescentes. Selon la zone barrière considérée, le matériau de cette zone barrière est soit le matériau de base de la première couche, soit le matériau de base de la deuxième couche. Dans le cas d'une fabrication par évaporation sous vide telle que mentionnée ci-dessus, on réalise avantageusement cette zone en supprimant toute co-évaporation de dopant. Par suite de la diffusion de dopant(s) provenant de zones adjacentes (zone dopée ou/et zone électroluminescente), cette zone barrière peut contenir un ou des dopants de ces zones adjacentes, en faible proportion, et, notamment, en beaucoup plus faible proportion que dans ces zones adjacentes.

De préférence, l'épaisseur de chaque zone barrière de diffusion est inférieure à 20 nm. L'épaisseur de cette zone est de préférence beaucoup plus faible que celle des zones dopées, pour limiter les pertes ohmiques dans l'épaisseur de la diode.

De préférence, si la cathode et l'anode sont en matériau conducteur respectivement M1 et M2 et si l'on appelle E_{M1} et E_{M2} le travail de sortie respectivement du matériau M1 et du matériau M2, si l'on appelle E_{O1C} l'affinité électronique ou énergie du niveau du LUMO et E_{O1V} le potentiel d'ionisation ou énergie du niveau du HOMO du premier matériau organique O1, et E_{O2C} l'énergie du niveau du LUMO et E_{O2V} l'énergie du niveau du HOMO du deuxième matériau organique 02, tous ces niveaux étant évalués positivement par rapport à l'énergie d'un électron dans le vide à l'infini, le matériau conducteur de la cathode, celui de l'anode, le premier et le deuxième matériaux organiques sont choisis de manière à ce que : E_{M1} ≥ E_{O1C} et E_{M2} ≤ E_{O2V}.

Ces conditions correspondent au caractère non ohmique de la jonction entre la cathode et la zone dopée n de la première couche, et de la jonction entre l'anode et la zone dopée p de la deuxième couche. Malgré la barrière de potentiel à ces jonctions mais grâce au dopage électronique des matériaux organiques des première et deuxième couches qui contribuent à diminuer l'épaisseur de cette barrière de potentiel, le courant électrique traverse ces jonctions avec des pertes électriques réduites.

De préférence, le matériau conducteur de la cathode, celui de l'anode, le premier et le deuxième matériaux organiques sont choisis de manière à ce que, en outre : E_{O2C} < E _{O1C} et/ou E_{O1V} > E_{O2V}.

Ces conditions permettent le blocage des électrons et/ou celui des trous à l'interface entre les deux couches. Pour aboutir à un blocage plus efficace, il est préférable que la différence entre ces niveaux de LUMO d'une part, et ces niveaux de HOMO d'autre part, soient supérieures à 0,5 eV.

Il n'est pas forcément nécessaire d'obtenir à la fois le blocage des trous du côté de la cathode et le blocage des électrons du coté de l'anode. En effet, dans le cas où le premier matériau organique (du côté de la cathode) conduit mieux les électrons que les trous, il est moins utile de bloquer les trous ; dans le cas où le deuxième matériau organique (du côté de l'anode) conduit mieux les trous que les électrons, il est moins utile de bloquer les électrons.

De préférence, l'au moins une zone électroluminescente comprend au moins un dopant luminescent qui est choisi de manière à ce que son niveau de LUMO défini par E_{DLC} et son niveau de HOMO défini par E_{DLV} soit tels que E_{DLV} - E_{DLC} < E_{O1V} - E_{O1C} + 0,3 eV dans le cas d'une zone luminescente appartenant à la première couche, et que E _{DLV} - E_{DLC} < E_{O2V} - E_{O2C} + 0,3 eV dans le cas d'une zone luminescente appartenant à la deuxième couche.

Les dopants luminescents ont un niveau de LUMO et/ou un niveau de HOMO qui est compris dans la bande interdite du matériau « hôte » dans lequel ils sont incorporés ; on distingue la bande interdite du matériau « hôte » (ou « forbiden gap » en langue anglaise) qui est délimitée par le niveau de HOMO et le niveau de LUMO de ce matériau, et la bande interdite du dopant luminescent, qui est délimitée par le niveau de HOMO et le niveau de LUMO propres à ce dopant ; pour un dopage luminescent efficace, il importe que la largeur de la bande interdite de ce dopant soit inférieure à la largeur de la bande interdite du matériau « hôte » à 0,3 eV près. De préférence, le niveau de LUMO et le niveau de HOMO de ce dopant sont tous les deux compris dans la bande interdite du matériau dans lequel ils sont incorporés, ce qui améliore le rendement de la diode.

Dès lors qu'un dopant luminescent ou colorant présente un niveau de LUMO et/ou un niveau de HOMO compris dans la bande interdite du matériau dans lequel il est incorporé, ce niveau ne peut contribuer à un dopage n ou p de type électronique. On peut donc bien distinguer les dopants électroniques des zones dopées n ou p des dopants luminescents des zones luminescentes.

De préférence, le premier et le deuxième matériaux organiques, et l'au moins un dopant luminescent sont choisis de manière à ce que E_{DLV} - E_{DLC} < E_{O2V} - E_{O1C} + 0,3 eV et à ce que E_{DLV} - E_{DLC}< E_{O1V} - E_{O2C} + 0,3 eV.

Ces conditions permettent de limiter avantageusement la formation « d' exciplex », c'est-à-dire de limiter la désexcitation ou recombinaison des paires électrons-trous via la mise en commun de deux niveaux d'énergie correspondant à des matériaux différents.

Le premier matériau organique est choisi dans le groupe constitué par le Bphen, l'Alq3, le BCP, le DPVBi, et le TPBi et le deuxième matériau organique est choisi dans le groupe constitué par le Spiro-TAD, le TAZ et le TCTA.

Le BCP, le DPVBi, et le TPBi correspondent respectivement au 2,9-diméthyl-4,7-diphényl-1,10-phénanthroline (ou bathocuproine), au 4,4-bis(2,2-diphénylrylène, et au 2,2',2"-(1,3,5-phénylène)tris[1-phényl-1H-benzimidazole ; ces matériaux organiques présentent une bande interdite (écart entre niveau du HOMO et niveau du LUMO) suffisamment large pour former des matériaux « hôte » bien adaptés pour accueillir des dopants luminescents qui émettent une lumière de teinte bleue.

L'invention a également pour objet un panneau d'affichage d'images ou d'éclairage caractérisé en ce qu'il comprend une pluralité de diodes selon l'invention. Le panneau obtenu est particulièrement économique et présente un très bon rendement.

L'invention sera mieux comprise à la lecture de la description qui va suivre, donnée à titre d'exemple non limitatif, et en référence aux figures annexées sur lesquelles :
- la figure 1, déjà décrite, représente une structure de diode organique électroluminescente selon l'art antérieur ;
- les figures 2 à 4 représentent trois modes de réalisation différents de diodes à deux couches organiques : à une seule zone électroluminescente appartenant à la couche organique du côté de l'anode pour la figure 2 , cas ne faisant pas partie de l'invention , à une seule zone électroluminescente appartenant à la couche organique du côté de la cathode pour la figure 3 , cas ne faisant pas partie de l'invention , à deux zones électroluminescentes adjacentes, l'une appartenant à la couche organique du côté de l'anode, l'autre appartenant à la couche organique du côté de la cathode, pour la figure 4 , selon l'invention ;
- la figure 5 représente un mode de réalisation particulier où les deux matériaux organiques O1 et O2 sont identique , cas ne faisant pas partie de l'invention ; l'unique matériau est alors appelé O ;
- la figure 6 décrit un dispositif de mesure électrique permettant de contrôler le taux de dopage électronique de couches organiques ;
- les figures 7 et 8 représentent les caractéristiques électriques et lumineuses, et les efficacités des diodes obtenues selon l'exemple 1 ;
- les figures 9 et 10 représentent les caractéristiques électriques et lumineuses, et les efficacités des diodes obtenues selon l'exemple 2 .

Afin de simplifier la description et de faire apparaître les différences et avantages que présente l'invention par rapport à l'état antérieur de la technique, on utilise des références identiques pour les éléments qui assurent les mêmes fonctions.

Du choix des matériaux de la cathode, de l'anode, du matériau organique O1 du côté de la cathode, et du matériau organique 02 du côté de l'anode, du dopant luminescent, dépendent largement les performances et l'efficacité de la diode organique obtenue ; on appelle :
- E_{M1} le travail de sortie du matériau M1 de la cathode, E_{M2} celui du matériau M2 de l'anode,
- E_{O1C} l'énergie du niveau du LUMO et E_{O1V} l'énergie du niveau du HOMO du matériau O1,
- E_{O2C} l'énergie du niveau du LUMO et E_{O2V} l'énergie du niveau du HOMO du matériau 02,
- et E_{DLC} l'énergie du niveau du LUMO et E_{DLV} l'énergie du niveau du HOMO du dopant luminescent.

On choisit de préférence ces matériaux et ce dopant de manière à ce que :
- a) E_{M1} ≥ E_{O1C} et E_{M2} ≤ E_{O2V} ; ces conditions expriment que les jonctions entre électrodes et matériaux organiques ne sont pas ohmiques ;
- b) b-1) E_{O2C} < E_{O1C} et b-2) E_{O1V} > E_{O2V} ; ces conditions expriment que les électrons circulant dans la première couche sont dissuadés de passer dans la deuxième couche, et que les trous circulant dans la deuxième couche sont dissuadés de passer dans la première couche ;
- c) E_{DLV} - E_{DLC} < E_{O1V} - E_{O1C} + 0,3 eV si le dopant luminescent dope une zone de la première couche, et E_{DLV} - E_{DLC} < E_{O2V} - E_{O2C} + 0,3 eV si le dopant luminescent dope une zone de la deuxième couche ; comme indiqué précédemment et comme illustré à la figure 4, les deux cas peuvent se produire simultanément ;
- d) d-1) E_{DLV} - E_{DLC} < E_{O2V} - E_{O1C} + 0,3 eV et d-2) E_{DLV} - E_{DLC} < E_{O1V} - E_{O2C} + 0,3 eV, ce qui limite la formation d'exciplex et permet d'améliorer le rendement.

Le choix des matériaux étant réalisé, on réalise ensuite l'empilement suivant, de préférence par évaporation sous vide, sur un substrat en verre ou sur une matrice active :
- une anode 1, d'épaisseur généralement comprise entre 10 nm et 200 nm ;
- une couche, à base de matériau organique 02, d'épaisseur généralement comprise entre 30 nm et 200 nm ; dans une première étape de dépôt du matériau organique 02, on co-évapore un dopant donneur de trous (c'est-à-dire accepteur d'électrons), de manière à former une zone 2 dopée p d'épaisseur supérieure à 20 nm ; optionnellement, dans une deuxième étape d'évaporation sous vide du même matériau organique 02, on poursuit ensuite le dépôt sans co-évaporation de dopant, de manière à former une zone barrière 3 non dopée, d'épaisseur inférieure à 20 nm ;
- une couche, à base de matériau organique O1, d'épaisseur généralement comprise entre 30 nm et 200 nm ; dans une première étape optionnelle d'évaporation sous vide du matériau organique O1, on dépose le matériau O1 sans co-évaporation de dopant, de manière à obtenir une zone barrière 5 non dopée d'épaisseur inférieure à 20 nm ; dans une deuxième étape d'évaporation sous vide du même matériau organique O1, on poursuit le dépôt en co-évaporant un dopant donneur d'électrons de manière à former une zone 6 dopée n d'épaisseur supérieure à 20 nm ;
- une cathode 7, d'épaisseur généralement comprise entre 10 nm et 200 nm.

A la fin du dépôt de matériau organique 02 et au début du dépôt de matériau organique O1, on procède à ce dépôt en co-évaporant un dopant électroluminescent, de manière à former deux zones électroluminescentes 4, 4' à l'interface entre les deux couches, présentant généralement une épaisseur supérieure ou égale à 20 nm.

Après le dépôt de la formation de l'ensemble des zones dans chaque couche, on dépose ensuite d'une manière connue en elle-même une couche d'encapsulation destinée à protéger les couches organiques précédemment déposées contre les risques de dégradation, notamment par l'oxygène et l'humidité de l'air ambiant.

On obtient une diode selon l'invention.

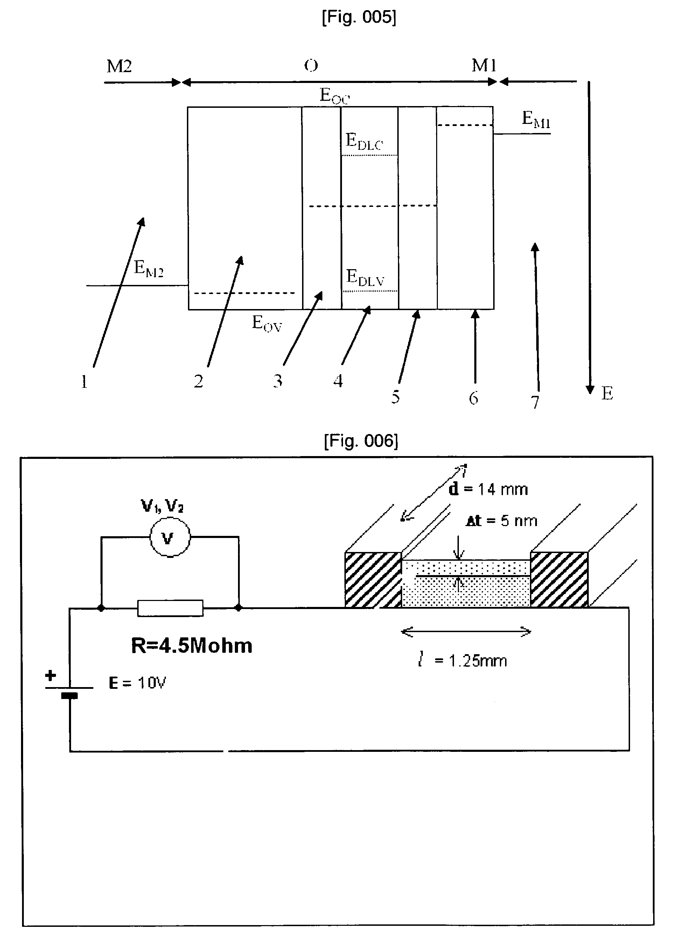

En référence aux figures 2 à 5, on trouve trois modes de réalisation différents de diodes à seulement au maximum deux couches organiques : à une seule zone électroluminescente 4 appartenant à la couche organique en matériau 02 du côté de l'anode pour la figure 2 , cas ne faisant pas partie de l'invention , à une seule zone électroluminescente 4' appartenant à la couche organique en matériau O1 du côté de la cathode pour la figure 3 , cas ne faisant pas partie de l'invention , à deux zones électroluminescentes adjacentes 4, 4', l'une 4 appartenant à la couche organique en matériau 02 du côté de l'anode, l'autre 4' appartenant à la couche organique en matériau O1 du côté de la cathode, pour la figure 4 , selon l'invention ; à noter enfin, en référence à la figure 5, un mode de réalisation particulier où les deux matériaux organiques O1 et O2 sont identiques, l'unique matériau étant alors appelé O , cas ne faisant pas partie de l'invention.

Selon une variante de l'invention , la structure est inversée, à savoir qu'on commence par déposer la cathode, puis la couche en matériau O1, puis la couche en matériau 02, puis l'anode.

A noter que si les zones barrières précédemment décrites 3, 5 apportent un avantage du fait du blocage des électrons ou des trous, ces zones barrières restent néanmoins optionnelles.

Les diodes obtenues présentent de très bons rendements et une très bonne efficacité, alors qu'elles sont particulièrement économiques à fabriquer du fait qu'elles ne comportent au maximum que deux couches organiques à base de matériaux organiques différents.

Les exemples suivants illustrent des modes de réalisations pour les figures 2 et 3.

### Exemple 1, cas ne faisant pas partie de l'invention:

Cet exemple a pour but d'illustrer un mode de réalisation tel que représenté à la figure 3, où la diode ne comprend qu'une seule zone luminescente qui est comprise dans la couche à base de matériau O1 qui est au contact de la cathode.

Par évaporation sous vide (sauf pour l'anode), on réalise d'une manière connue l'empilement suivant sur un substrat en verre :
- une anode 1 en ITO, d'épaisseur 150 nm, par exemple par pulvérisation cathodique ;
- une couche, à base de matériau organique 02 = Spiro-TAD, abréviation correspondant au composé dénommé 2,2',7,7'-tétrakis(diphényl-amine)-9,9'-spiro-bifluorène, et d'épaisseur totale 45 nm ; dans une première étape d'évaporation sous vide du Spiro-TAD destinée à former une zone 2 dopée p, on co-évapore un dopant donneur de trous (accepteur d'électrons), ici du F4-TCNQ, abréviation correspondant au composé dénommé tétra-fluoro-tétra-cyano-quino-diméthane, de manière à ce que l'épaisseur de la zone dopée p soit approximativement de 35 nm ; le niveau de dopage est ajusté à 2% en masse environ, à l'aide d'un dispositif classique basé sur une balance à quartz intégré dans l'enceinte de dépôt ; dans une deuxième étape d'évaporation sous vide du même Spiro-TAD destinée à former une zone barrière 3, on poursuit ensuite le dépôt sans co-évaporation de dopant, de manière à obtenir une zone barrière 3 non dopée d'épaisseur approximative de 10 nm ;
- une couche, à base de matériau organique O1 = Bphen, abréviation correspondant au composé dénommé bathophénanthroline, ou, plus précisément, 4,7-diphenyl-1,10-phénanthroline et d'épaisseur totale approximative de 72 nm ; dans une première étape d'évaporation sous vide du BPhen destinée à former une zone électroluminescente 4', on co-évapore un dopant luminescent formé par du rubrène de manière à obtenir un dopage de 20% environ en poids de rubrène sur une épaisseur de zone électroluminescente 4' d'environ 32 nm ; dans une deuxième étape d'évaporation sous vide du même BPhen destinée à former une autre zone barrière 5, on poursuit ensuite le dépôt sans co-évaporation de dopant, de manière à obtenir une zone barrière 5 non dopée d'épaisseur approximative de 5 nm ; dans une troisième étape d'évaporation sous vide du Bphen destinée à former une zone 6 dopée n, on poursuit le dépôt du BPhen en co-évaporant un donneur d'électrons formé par du césium de manière à obtenir une épaisseur de zone 6 dopée n d'environ 35 nm et un niveau de dopage compris entre 10 et 20 mV pour 10 nm d'épaisseur de couche déposée ; ce niveau de dopage est évalué comme suit, en utilisant le dispositif de mesure représenté à la figure 6 ; dans l'enceinte de dépôt, le matériau O1 est déposé simultanément entre deux électrodes métalliques (section hachurée sur la figure) qui sont distantes de 1= 1,25 mm, s'étendent sur d = 14 mm, et qui sont reliées à un dispositif de mesure de résistance qui comprend un générateur de tension continue E = 10 V et une résistance étalon R = 4,5 MΩ reliés en série_ ; la variation de la tension aux bornes de la résistance en fonction de l'épaisseur déposée (prise par échelons de 10 nm ici) donne une valeur proportionnelle au niveau de dopage en césium.
- une cathode 7 en aluminium, d'épaisseur 150 nm.

On dépose ensuite d'une manière connue en elle-même une couche d'encapsulation (non représentée) destinée à protéger les couches organiques précédemment déposées contre les risques de dégradation, notamment par l'oxygène et l'humidité de l'air ambiant.

Si l'on appelle E_{M1}= 4,3 eV le travail de sortie de l'aluminium, E_{M2}= 4,5 à 5,0 eV celui de l'ITO, si l'on appelle E_{O1C}= 3,0 eV l'énergie du niveau du LUMO et E_{O1V}= 6,3 eV l'énergie du niveau du HOMO du BPhen, E_{O2C}= 2,4 eV l'énergie du niveau du LUMO et E_{O2V}= 5,3 eV l'énergie du niveau du HOMO du Spiro-TAD, E_{DLC}= 3,0 eV l'énergie du niveau du LUMO et E_{DLV}= 5,3 eV l'énergie du niveau du HOMO du dopant luminescent rubrène, on constate que le choix des matériaux et du dopant luminescent correspond quasiment à toutes les conditions avantageuses a) à d) :
- a) E_{M1} (4,3) ≥ E_{O1C} (3,0) et E_{M2} (4,5 à 5,0) ≤ E_{O2V} (5,3)
- b) E_{O2C} (2,4) << E_{O1C} (3,0) et E_{O1V} (6,3) >> E_{O2V} (5,3)
- c) E_{DLV} - E_{DLC} (= 2,3 eV) < E_{O2V} - E_{O2C} + 0,3 eV (= 3,2 eV) puisque le dopant luminescent dope une zone de la deuxième couche ;
- d) E_{DLV} - E_{DLC} (= 2,3 eV) < E_{O2V} - E_{O1C} + 0,3 eV (= 2,6 eV) et E_{DLV} - E_{DLC} < E_{O1V} - E_{O2C} + 0,3 eV.

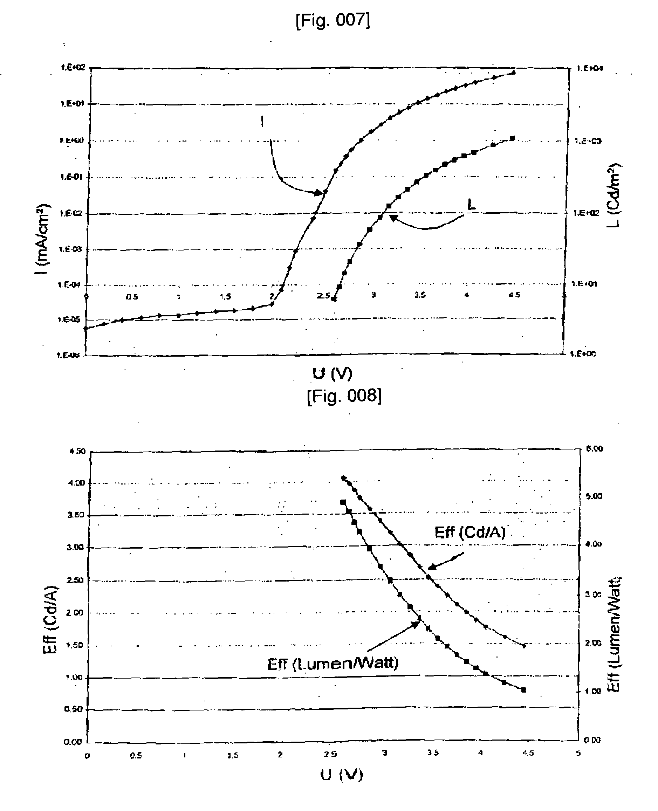

Les performances électriques et lumineuses de la diode ainsi obtenue sont représentées aux figures 7 et 8 ; la figure 7 montre la valeur du courant 1 (mA/cm2) et de la luminance L (Cd/m2) en fonction de la tension U (V) aux bornes de la diode : 1 mA/cm2 donne 35,7 Cd/m2 et nécessite une tension de 2,85 V ; la figure 8 montre deux valeurs d'efficacité lumineuse, l'une en Cd/A, l'autre en Lumen/Watt : à 100 Cd/m2 et une tension de 3,09 V, l'efficacité est de 3,12 Cd/A et de 3,17 Lm/W.

On voit donc qu'on obtient des performances et des rendements tout à fait acceptables avec une structure de diode particulièrement simple et économique.

### Exemple 2 , ne faisant pas partie de l'invention:

Cet exemple a pour but d'illustrer un autre mode de réalisation tel que représenté à la figure 2, où la diode ne comprend qu'une seule zone luminescente qui est comprise dans la couche à base de matériau 02 qui est au contact de l'anode.

Les matériaux de base de la cathode, de la première couche organique, de la deuxième couche organique, de l'anode, et du dopant luminescent sont identiques à ceux de l'exemple 1. On procède comme dans l'exemple 1, aux différences près :
- qu'après la deuxième étape de dépôt de la couche à base de matériau organique 02 = Spiro-TAD lors de laquelle on réalise une couche barrière 3, on ajoute une troisième étape d'évaporation sous vide de Spiro-TAD destinée à former une zone électroluminescente 4, en co-évaporant évapore du rubrène de manière à obtenir un dopage de 20% environ en poids de rubrène sur une épaisseur de zone électroluminescente 4 d'environ 32 nm ; l'épaisseur totale de la couche à base de spiro-TAD est alors d'environ 77 nm ;
- qu'on supprime la première étape de formation de zone électroluminescente dans la couche à base de matériau organique O1 = Bphen, en passant directement à l'étape de formation de la couche barrière 5 ; l'épaisseur totale de la couche à base de BPhen est alors d'environ 40 nm ;

Comme pour l'exemple 1 et puisque les matériaux et le dopant sont identiques, on constate que le choix des matériaux et du dopant luminescent correspond comme précédemment à toutes les conditions avantageuses a) à d) ; seule la condition c) a changé puisque le dopant luminescent dope maintenant une zone de la première couche ; cette condition est bien vérifiée puisque : E_{DLV} - E_{DLC} (= 2,3 eV) < E _{O1V}- E_{O1C} + 0,3 eV (= 3,6 eV) ;

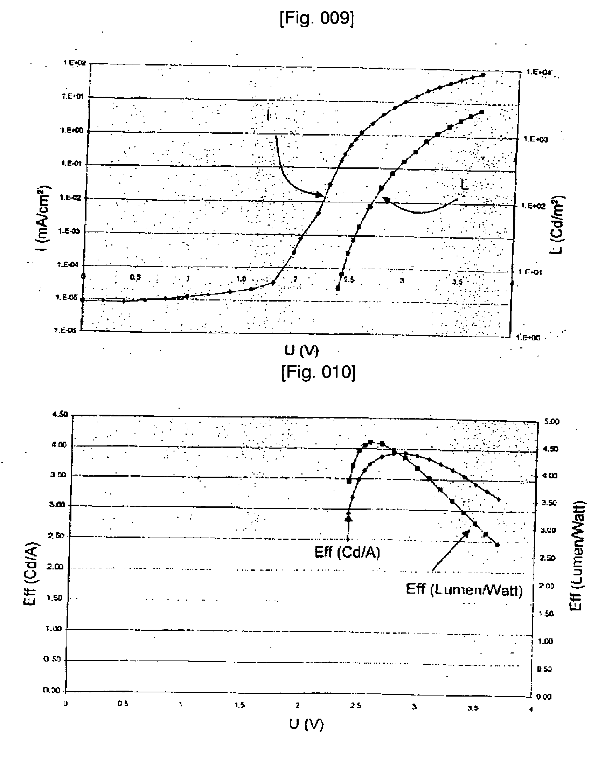

Les performances électriques et lumineuses de la diode sont représentées aux figures 9 et 10 ; la figure 9 montre la valeur du courant I (mA/cm2) et de la luminance L (Cd/m2) en fonction de la tension U (V) aux bornes de la diode : 1 mA/cm2 donne 37,1 Cd/m2 et nécessite une tension de 2,57 V ; la figure 10 montre deux valeurs d'efficacité lumineuse, l'une en Cd/A, l'autre en Lumen/Watt : à 100 Cd/m2 et une tension de 2,7 V, l'efficacité est de 3,88 Cd/A et de 4,51 Lm/W.

Ce deuxième exemple illustre donc bien l'obtention de performances et de rendements tout à fait acceptables avec une structure de diode particulièrement simple et économique.

### Exemple 3, ne faisant pas partie de l'invention :

Cet exemple a pour but d'illustrer un autre mode de réalisation en référence à la figure 2, où la diode ne comprend qu'une seule zone luminescente qui est comprise dans la couche à base de matériau 02 qui est au contact de l'anode.

A l'aide d'un procédé comparable à celui décrit à l'exemple 2, en utilisant les mêmes taux de dopage et les mêmes épaisseurs, on réalise l'empilement suivant : ITO /TAZ dopé F4TCNQ / TAZ / TAZ dopé Irppy / Bphen / Bphen dopé Cs / Al. Le matériau organique de la deuxième couche est ici du TAZ, nom abrégé du 3-(4-biphénylyl)-4-phényl-5-tert-butylphényl-1,2,4-triazole. Le dopant luminescent est ici du Irppy, nom abrégé du tris[2-(2-pyridinyl)phényl-C,N]-iridium.

Si l'on appelle E_{M1}= 4,3 eV le travail de sortie de l'aluminium, E_{M2}= 4,5 à 5,0 eV celui de l'ITO, si l'on appelle E_{O1C}= 3,0 eV l'énergie du niveau du LUMO et E_{O1V}= 6,3 eV l'énergie du niveau du HOMO du BPhen, E_{O2C}= 2,6 eV l'énergie du niveau du LUMO et E_{O2V}= 6,6 eV l'énergie du niveau du HOMO du TAZ, E_{DLC}= 2,4 eV l'énergie du niveau du LUMO et E_{DLV}= 5,4 eV l'énergie du niveau du HOMO du dopant luminescent Irppy, on constate que le choix des matériaux et du dopant luminescent correspond quasiment à toutes les conditions avantageuses a) à d) :
- a) E_{M1} (4,3) ≥ E_{O1C} (3,0) et E_{M2} (4,5 à 5,0) ≤ E_{O2V} (6,6)
- b) E_{O2C} (2,6) << E_{O1C} (3,0), ce qui permet d'assurer le blocage des électrons ; par contre, l'inégalité E_{O1V}(6,3) >> E_{O2V} (6,6) étant fausse, on n'assure pas d'une manière efficace le blocage des trous ;
- c) E_{DLV} - E_{DLC} (= 3,0 eV) < E_{O2V}- E_{O2C} + 0,3 eV (= 4,3 eV) puisque le dopant luminescent dope une zone de la deuxième couche ;
- d) E_{DLV} - E_{DLC} (= 3,0 eV) < E_{O2V}- E_{O1C} + 0,3 eV (= 3,9 eV) et E_{DLV} - E_{DLC} (= 3,0 eV) < E_{O1V} - E_{O2C} + 0,3 eV (4 eV) ; on constate ici que les deux conditions de limitation des exiplex sont réunies, comme dans les deux exemples précédents.

La diode obtenue présente des performances électriques et lumineuses tout à fait comparable à celle des exemples 1 et 2.

### Exemple 4, ne faisant pas partie de l'invention :

Cet exemple a pour but d'illustrer un autre mode de réalisation en référence à la figure 3, où la diode ne comprend qu'une seule zone luminescente qui est comprise dans la couche à base de matériau O1 qui est au contact de la cathode.

A l'aide d'un procédé comparable à celui décrit à l'exemple 1, en utilisant les mêmes taux de dopage et les mêmes épaisseurs, on réalise l'empilement suivant : ITO /TCTA dopé F4TCNQ / TCTA / Alq3 dopé rubrène / Alq3 / Alq3 dopé Li / Al. Le matériau organique O1 de la première couche est ici de l'Alq3, nom abrégé du tris(8-hydroxy quinoline) aluminium. Le matériau organique 02 de la deuxième couche est ici du TCTA, nom abrégé du 4,4',4'-tri(N-carbazol)triphényl-amine. Le dopant luminescent est ici à nouveau du rubrène.

Si l'on appelle E_{M1}= 4,3 eV le travail de sortie de l'aluminium, E_{M2}= 4,5 à 5,0 eV celui de l'ITO, si l'on appelle E_{O1C}= 2,9 eV l'énergie du niveau du LUMO et E_{O1V}= 6,0 eV l'énergie du niveau du HOMO de l'Alq3, E_{O2C}= 2,7 eV l'énergie du niveau du LUMO et E_{O2V}= 5,8 eV l'énergie du niveau du HOMO du TCTA, E_{DLC}= 3,0 eV l'énergie du niveau du LUMO et E_{DLV}= 5,3 eV l'énergie du niveau du HOMO du dopant luminescent rubrene, on constate que le choix des matériaux et du dopant luminescent correspond quasiment à toutes les conditions avantageuses a) à d) :
- a) E_{M1} (4,3) ≥ E_{O1C} (2,9) et E_{M2} (4,5 à 5,0) ≤ E_{O2V} (5,8)
- b) E_{O2C} (2,7) < E_{O1C} (2,9) et E_{O1V} (6,0) > E_{O2V} (5,8) ;
- c) E_{DLV} - E_{DLC} (= 2,3 eV) < E_{O1V} - E_{O1C} + 0,3 eV (= 3,4 eV) puisque le dopant luminescent dope une zone de la première couche ;
- d) E_{DLV} E_{DLC} (= 2,3 eV) < E_{O2V} - E_{O1C} + 0,3 eV (= 3,2 eV) et E_{DLV} - E_{DLC} (= 3,0 eV) < E_{O1V} - E_{O2C} + 0,3 eV (3,6 eV) ; on constate ici que les deux conditions de limitation des exiplex sont réunies.

La diode obtenue présente des performances électriques et lumineuses tout à fait exceptionnelles puisque toutes les conditions sont réunies.

L'invention s'applique notamment aux panneaux de diodes électroluminescentes, par exemple pour éclairage ou pour affichage d'images ; il est évident pour l'homme du l'art qu'elle peut s'appliquer à tout système incorporant une pluralité de diodes organiques électroluminescentes sans sortir du cadre des revendications ci-après.

## Revendications

1. Diode organique électroluminescente comprenant :
- une cathode (7) et une anode (1),
et, intercalée entre ladite cathode et ladite anode,
- une première couche au contact de ladite cathode, à base d'un premier matériau organique (O1), qui est dopé n dans une zone (6) de cette couche qui est au contact de cette cathode (7),
- une deuxième couche au contact de ladite anode, à base d'un deuxième matériau organique (02), qui est dopé p dans une zone (2) de cette couche qui est au contact de cette anode (6),
- où ladite première couche et ladite deuxième couche comprennent une zone électroluminescente (4 ; 4') qui est au contact de l'autre couche, et qui n'est ni dopée n, ni dopée p ;
- où ledit deuxième matériau organique (02) est différent dudit premier matériau organique (O1),
**caractérisée en ce que** :
- l'épaisseur de la zone dopée n (6) de la première couche et celle de la zone dopée p (2) de la deuxième couche sont supérieures à 20 nm,
- le premier matériau organique (O1) est choisi dans le groupe constitué par le 4,7-diphenyl-1,10-phénanthrline (Bphen) le 29-dimethyl-4,7-diphényl-110 phénanthroline (BCP) le 4,4-bis(2,2-diphénybléne)y (DPVB0), le 2,2',2"-(1,3,5-phényléne)tris[1-phényl-1H-benzimidazole] (TPBi) et tetris(8-hydroxyquinoline aluminium (Alq3) et le deuxième matériau organique (02) est choisi dans le groupe constitué par le 2,2',7,7'-tetrakis(diphényl-amine)-9,9'-spiro-bifluoréne (Spiro-TAD), le 3-(4-biphéylyl)-4-phényl-5-tert-butylphéyl-1,2,4-triazole (TAZ). et le 4,4,4-tri(N-carbazol)triphényl-amine (TCTA).

2. Diode selon la revendication 1 **caractérisée en ce qu'**elle comprend également au moins une zone barrière de diffusion (3, 5), qui n'est pas substantiellement dopée, et qui est intercalée entre une desdites zones dopées (2 ; 6) et une desdites zones électroluminescentes (4 ; 4').

3. Diode selon la revendication 2 **caractérisée en ce que** l'épaisseur de chaque zone barrière de diffusion (3, 5) est inférieure à 20 nm.

4. Diode selon l'une quelconque des revendications précédentes, **caractérisée en ce que**, si la cathode et l'anode sont en matériau conducteur respectivement (M1) et (M2) et si l'on appelle E_{M1} et E_{M2} le travail de sortie respectivement du matériau (M1) et du matériau (M2), si l'on appelle E_{O1C} l'affinité électronique ou énergie du niveau du LUMO et E_{O1V} le potentiel d'ionisation ou énergie du niveau du HOMO du premier matériau organique (O1), et E_{O2C} l'énergie du niveau du LUMO et E_{O2V} l'énergie du niveau du HOMO du deuxième matériau organique (02), tous ces niveaux étant évalués positivement par rapport à l'énergie d'un électron dans le vide à l'infini, le matériau conducteur de la cathode, celui de l'anode, le premier et le deuxième matériaux organiques sont choisis de manière à ce que : E_{M1} ≥ E_{O1C} et E_{M2} ≤ E_{O2V}.

5. Diode selon la revendication 4 **caractérisée en ce que** le premier et le deuxième matériaux organiques sont choisis de manière à ce que, en outre : E_{O2C} < E_{O1C} et/ou E_{O1V} > E_{O2V}.

6. Diode selon la revendication 4 ou 5, **caractérisée en ce qu'**au moins une zone électroluminescente (4 ; 4') comprend au moins un dopant luminescent qui est choisi de manière à ce que son niveau de LUMO défini par E_{DLC} et son niveau de HOMO défini par E_{DLV} soit tels que E_{DLV} - E_{DLC} < E_{O1V} - E_{O1C} + 0,3 eV dans le cas d'une zone luminescente appartenant à la première couche, et que E_{DLV} - E_{DLC} < E_{O2V} - E_{O2C} + 0,3 eV dans le cas d'une zone luminescente appartenant à la deuxième couche.

7. Diode selon la revendication 6 **caractérisée en ce que** le premier et le deuxième matériaux organiques, et l'au moins un dopant luminescent sont choisis de manière à ce que E_{DLV} - E_{DLC} < E_{O2V} - E_{O1C} + 0,3 eV et à ce que E_{DLV} - E_{DLC} < E_{O1V} - E_{O2C} + 0,3 eV.

8. Panneau d'affichage d'images ou d'éclairage **caractérisé en ce qu'**il comprend une pluralité de diodes selon l'une quelconque des revendications précédentes.

## Claims

1. An organic light-emitting diode, comprising:
- a cathode (7) and an anode (1),
and, interposed between said cathode and said anode,
- a first layer in contact with said cathode, based on a first organic material (O1) which is n-doped in a zone (6) of this layer that is in contact with this cathode (7),
- a second layer in contact with said anode, based on a second organic material (02) which is p-doped in a zone (2) of this layer that is in contact with this anode (6),
- wherein said first layer and/or said second layer comprise an electroluminescent zone (4; 4') which is in contact with the other layer, and which is neither n-doped nor p-doped;
- wherein said second organic material (02) is different to said first organic material (O1),
**characterized in that** :
- the thickness of the n-doped zone (6) of the first layer and that of the p-doped zone (2) of the second layer are more than 20 nm,
- the first organic material is selected from the group consisting of 4,7-diphenly-1,10-phenanthroline (Bphen), 2,9-dimethyl-4,7-diphenyl-1,10-phenanthroline (BCP), 4,4'-bis(2,2' diphenyl vinyl)-1,1'-biphenyl (DPVBi), 2,2',2"-(1,3,5-Phenylene)tris(1-phenyl-1 H-benzimidazole) (TPBi) and tris(8-hydroxy-quinoline) aluminum Alq3, and the second organic material is selected from the group consisting of 2 ,2',7,7'-tetrakis(N,N-diphenylamino)-9,9-spirobifluorene (Spiro-TAD), 3-(Biphenyl4-yl)-4-phenyl-5-(4-tert-butylphenyl)-4H-1,2,4-triazole (TAZ) and 4,4',4"-Tris(carbazol-9-yl)-triphenylamine (TCTA).

2. The diode as claimed in claim, **characterized in that** it also comprises at least one diffusion barrier zone (3, 5) which is not substantially doped, and which is interposed between one of said doped zones (2; 6) and one of said electroluminescent zones (4; 4').

3. The diode as claimed in claim 2, **characterized in that** the thickness of each diffusion barrier zone (3, 5) is less than 20 nm.

4. The diode as claimed in any one of the preceding claims, **characterized in that**, if the cathode and the anode are made of conductive material (M1) and (M2) respectively, and if the work functions of the material (M1) and of the material (M2) are respectively denoted E_{M1} and E_{M2}, if E_{O1C} denotes the electron affinity or energy of the LUMO level and E_{O1V} denotes the ionization potential or energy of the HOMO level of the first organic material (O1), and E_{O2C} denotes the energy of the LUMO level and E_{O2V} denotes the energy of the HOMO level of the second organic material (02), all these levels being evaluated positively relative to the energy of an electron in a vacuum at infinity, then the conductive material of the cathode, that of the anode, and the first and second organic materials are selected so that: E_{M1} ≥ E_{O1C} and E_{M2} ≤ E_{O2V}.

5. The diode as claimed in claim 4, **characterized in that** the first and second organic materials are selected so that furthermore: E_{O2C} < E_{O1C} and/or E_{O1V} > E_{O2V}.

6. The diode as claimed in claim 4 or 5, **characterized in that** the at least one electroluminescent zone (4; 4') comprises at least one luminescent dopant which is selected so that its LUMO level defined by E_{DLC} and its HOMO level defined by E_{DLV} are such that E_{DLV} - E_{DLC} < E_{O1V} - E_{O1C} + 0.3 eV in the case of a luminescent zone belonging to the first layer, and such that E_{DLV} - E_{DLC} < E_{O2V} - E_{O2C} + 0.3 eV in the case of a luminescent zone belonging to the second layer.

7. The diode as claimed in claim 6, **characterized in that** the first and second organic materials, and the at least one luminescent dopant, are selected so that E_{DLV} - E_{DLC} < E_{O2V} - E_{O1C} + 0.3 eV and so that E_{DLV} - E_{DLC} < E_{O1V} - E_{O2C} + 0.3 eV.

8. Image-display or illumination panel, **characterized in that** it comprises a plurality of diodes as claimed in any one of the preceding claims.

## Patentansprüche

1. Elektrolumineszierende organische Diode mit:
- einer Kathode (7) und einer Anode (1) und zwischen der Kathode und der Anode:
- einer ersten, die Kathode kontaktierenden Schicht auf Basis eines ersten organischen Materials (O1), das in einem diese Kathode (7) kontaktierenden Bereich (6) dieser Schicht n-dotiert ist,
- einer zweiten, die Anode kontaktierenden Schicht auf Basis eines zweiten organischen Materials (02), das in einem diese Anode (6) kontaktierenden Bereich (2) dieser Schicht p-dotiert ist,
- bei der die erste Schicht und die zweite Schicht einen elektrolumineszierenden Bereich (4; 4') umfassen, der die andere Schicht kontaktiert und der weder n- noch p-dotiert ist,
- bei der das zweite organische Material (02) sich von dem ersten organischen Material (O1) unterscheidet, **dadurch gekennzeichnet, dass**
- die Dicke des n-dotierten Bereichs (6) der ersten Schicht und diejenige des p-dotierten Bereichs (2) der zweiten Schicht 20 nm übersteigen,
- das erste organische Material (O1) aus der Gruppe gewählt ist, die durch 4,7-Diphenyl-1,10-phenanthrolin (Bphen), 2,9-Dimethyl-4,7-diphenyl-1,10-phenanthrolin (BCP), 4,4'-Bis(2,2-diphenylvinyl)-1,1'-biphenyl (DPVBi), 2,2'2"-(1,3,5-Phenylen)tris(1-phenyl-1H-benzimidazol (TPBi) und Tris(8-hydroxyquinolin)aluminium (Alq3) gebildet ist, und das zweite organische Material (02) aus der Gruppe gewählt ist, die durch 2,2',7,7'-Tetrakis(diphenylamino)-9,9'-spirobifluoren (Spiro-TAD), 3-(4-Biphenylyl)-4-phenyl-5-tert-butylphenyl-1,2,4-triazol (TAZ) und 4,4',4"-Tris(N-carbazol)-triphenylamin (TCTA) gebildet ist.

2. Diode nach Anspruch 1, **dadurch gekennzeichnet, dass** sie ferner mindestens einen Diffusionssperrbereich (3, 5) umfasst, der nicht wesentlich dotiert ist und der zwischen einem der dotierten Bereiche (2; 6) und einem der elektrolumineszierenden Bereiche (4; 4') angeordnet ist.

3. Diode nach Anspruch 2, **dadurch gekennzeichnet, dass** die Dicke des jeweiligen Diffusionssperrbereichs (3, 5) geringer als 20 nm ist.

4. Diode nach einem der vorhergehenden Ansprüche, **dadurch gekennzeichnet, dass**, wenn die Kathode und die Anode aus einem leitenden Material (M1) beziehungsweise (M2) bestehen und wenn die Austrittsarbeit des Materials (M1) beziehungsweise des Materials (M2) mit E_{M1} beziehungsweise E_{M2} bezeichnet wird, wenn mit E_{O1C} die elektronische Affinität bzw. Energie des LUMO-Niveaus und mit E_{O1V} das Ionisierungspotenzial bzw. die Energie des HOMO-Niveaus des ersten organischen Materials (O1) und mit E_{O2C} die Energie des LUMO-Niveaus und mit E_{O2V} die Energie des HOMO-Niveaus des zweiten organischen Materials (02) bezeichnet werden, wobei alle diese Niveaus positiv in Bezug auf die Energie eines Elektrons in dem gegen unendlich tendierenden Vakuum bewertet werden, das leitende Material der Kathode, dasjenige der Anode, das erste und das zweite organische Material derart gewählt sind, dass E_{M1} ≥ E_{O1C} und E_{M2} ≤ E_{O2V}.

5. Diode nach Anspruch 4, **dadurch gekennzeichnet, dass** das erste und das zweite organische Material derart gewählt sind, dass ferner E_{O2C} < E_{O1C} und/oder E_{O1V} > E_{O2V}.

6. Diode nach Anspruch 4 oder 5, **dadurch gekennzeichnet, dass** mindestens ein elektrolumineszierender Bereich (4; 4') mindestens einen lumineszierenden Dotierstoff umfasst, der derart gewählt ist, dass sein durch E_{DLC} definiertes LUMO-Niveau und sein durch E_{DLV} definiertes HOMO-Niveau sich zu E_{DLV} - E_{DLC} < E_{O1V} - E_{O1C} + 0,3 eV im Fall eines zu der ersten Schicht gehörenden lumineszierenden Bereichs und zu E_{DLV} - E_{DLC} < E_{O2V} - E_{O2C} + 0,3 eV im Fall eines zu der zweiten Schicht gehörenden lumineszierenden Bereichs ergeben.

7. Diode nach Anspruch 6, **dadurch gekennzeichnet, dass** das erste und das zweite organische Material und der mindestens eine lumineszierende Dotierstoff derart gewählt sind, dass E_{DLV} - E_{DLC} < E_{O2V} - E_{O1C} + 0,3 eV und dass E_{DLV} - E_{DLC} < E_{O1V} - E_{O2C} + 0,3 eV.

8. Bildschirm für die Anzeige von Bildern bzw. Leuchtbildschirm, **dadurch gekennzeichnet, dass** er eine Vielzahl von Dioden nach einem der vorhergehenden Ansprüche umfasst.
